Europäisches Patentamt

European Patent Office

Office européen des brevets

(11) Publication number: 0 061 034
B1

(12) EUROPEAN PATENT SPECIFICATION

(45) Date of publication of patent specification: 14.08.85

(51) Int. Cl.⁴: H 01 S 3/13, H 01 S 3/10

(21) Application number: 82101681.3

(22) Date of filing: 04.03.82

(54) Opto-electronic control circuit.

(30) Priority: 23.03.81 US 246804

(43) Date of publication of application:
29.09.82 Bulletin 82/39

(45) Publication of the grant of the patent:
14.08.85 Bulletin 85/33

(84) Designated Contracting States:
DE FR GB IT

(56) References cited:
EP-A-0 048 057
CA-A-1 101 923
US-A-4 166 985

IBM TECHNICAL DISCLOSURE BULLETIN, vol.
19, no. 11, April 1977, pages 4474-4476, New
York (USA);

PATENT ABSTRACTS OF JAPAN, vol. 5, no. 3
(E-40)(675), 10th January 1981;

(73) Proprietor: International Business Machines
Corporation
Old Orchard Road
Armonk, N.Y. 10504 (US)

(72) Inventor: Comerford, Liam David
Box 191, RD 1
Carmel New York 10512 (US)

(74) Representative: Lancaster, James Donald
IBM United Kingdom Patent Operations Hursley
Park
Winchester, Hants, S021 2JN (GB)

Courier Press, Leamington Spa, England.

## Description

### Technical Field

This invention generally relates to control of the drive current for a light emitting semiconductor device and more particularly it relates to feedback control of bias current for an injection laser.

### Background Art

An injection laser is a semiconductor device which normally acts as an efficient and compact source of coherent light. Use is being made of such devices in data communications and in recording, printing and displaying apparatus.

In order to be operated satisfactorily in most applications, it is necessary that an injection laser be supplied with a bias current. Examples of use of a fixed value bias current for an injection laser may be found, for example, in U.S. Patents 3,319,080, 3,815,045, 3,925,735, 3,968, 399, and 4,027,179.

Feedback control of laser bias current is also known. If the bias current is controlled by a negative feedback system responsive to the light output, then there is compensation for differences in individual device characteristics and for time varying changes in device characteristics due, for example, to ageing or temperature changes.

Examples of the use of feedback control of bias current for an injection laser may be found in U.S. Patents 3,946,335 and 4,009,385 and in the following technical articles: J. Gruber et al., "Electronic Circuits for High Bit Rate Digital Fiber Optic Communications Systems", COM—26 IEEE Trans. Comm. 1088—1098 (July 1978); D. Smith, "Laser Level-control Circuit for High-bit-rate Systems Using a Slope Detector", 14 Elect. Lett. 775—6 (1978); P. Schumate et al., "GaAlAs Laser Transmitter for Lightwave Transmission Systems", 57 Bell Sys. Tech. Jour. 1823—1836 (1978).

All of these feedback systems are of the analog type, even when the injection laser modulation signal is digital in nature. This is apparent because there is no conversion of the sensed light amplitude into a digital code, and the bias current (as opposed to the modulation signal) for the injection laser is not produced by converting a digital representation into analog form. That the bias current is analog in character is also apparent from the continuous nature of the amplitude value it can assume. If the bias current were produced as a result of conversion from a digital code, the bias current could assume only discrete values in the steady state (after transients due to a change from one discrete value to another have disappeared). Thus, the prior art has used analog feedback to control the bias level of an injection laser even though the signals superimposed on the controlled bias level usually are digital in nature.

These prior art circuits are inherently difficult to monolithically integrate, since they include circuit elements such as capacitors and inductors which are inherently difficult to integrate.

These circuit elements are needed in such analog circuits because of the need to have one or more low pass networks. Such networks are used, for example, to prevent the modulation signal from adversely affecting the negative feedback bias stabilization system and in the feedback system itself to perform operations such as mathematical integration. These prior art circuits also provide no extended or flexible set of control or test functions since each additional function requires additional circuitry. As a result, the prior art control circuits lack versatility. Different modes of operation and/or different applications usually require a different control circuit.

Monolithic integration offers cost and performance advantages over other methods of implementation. It also makes the size of the control system sufficiently small that it can be placed in the same module as the injection laser and associated output optical fiber. An extended set of control and test functions, furthermore offers the flexibility in application, which is generally associated with digital circuit elements.

IBM Technical Disclosure Bulletin Vol. 19 No. 11, April 1977 pages 4474—4476 discloses a feedback control circuit for a laser, and the introductory part of claim 1 refers to it. The circuit includes a digital counter, and a digital to analogue converter for generating the laser drive current. However the circuit is concerned with precisely maintaining the laser "on" level. As indicated in the characterising part of claim 1, this invention is concerned with maintaining the laser output within an intermediate range. The invention is particularly applicable to a feedback control circuit including a modulating signal input connection for modulating the laser drive current.

It is an object of this invention to provide a bias current control circuit for an injection laser which can be readily integrated monolithically.

A further object is to provide this control circuit with an extended and flexible set of control, modulation, and test functions.

Another object is to provide such a control circuit which can be manufactured and tested on a conventional manufacturing line for digital components.

Still another object is to provide such a control circuit in a size sufficiently small that it can be packaged in the same module as the injection laser and associated output optical fiber.

It is also an object to provide a digital control circuit for an injection laser.

### Disclosure of Invention

Drive current for a light emitting semiconductor device, such as an injection laser, is supplied by a digitally programmable current source capable of supplying any one of a plurality of different discrete current amplitudes. The amplitudes of light being emitted by the device is sensed and digitally encoded. A logic circuit responsive to the digitally encoded light output level, and optionally responsive to other digital signals as well, controls the discrete current amplitude supplied by the programmable current source.

When the preferred embodiment is used for digital (or analog) communications, for example, the digitally programmable current source supplies bias current for the injection laser. Modulation current is added to this bias current to form the total drive current for the laser. In another mode of operation, modulated drive current is supplied by the programmable current source.

Brief Description of the Drawings

FIG. 1 is a general block diagram of a digital controller for the bias current of a light emitting semiconductor device in accordance with this invention.

FIG. 2 is a block diagram of a preferred embodiment of the digital controller.

FIG. 3 is a graphical representation of the output power curve of a typical injection laser as a function of drive current with three digitally encoded regions defined.

FIG. 4 is a schematical representation of the preferred embodiment shown also in Fig. 2.

Best Mode for Carrying Out the Invention

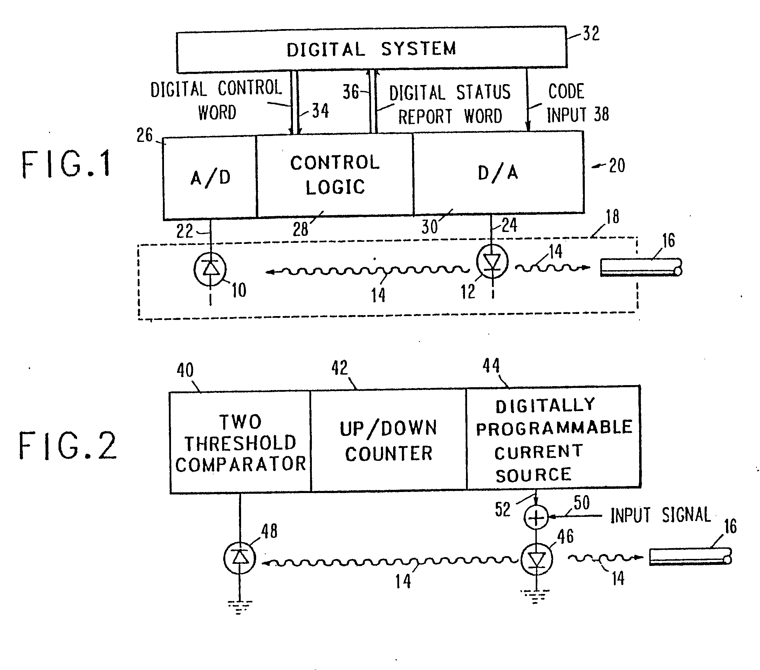

A light sensitive device 10 is positioned with respect to a light emitting semiconductor device 12 such that it responds to light 14 emitted by device 12. Light 14 from device 12 also travels in other directions, where it performs one or more useful functions. For example, the light 14 may be coupled into an optical fiber 16 as shown in Figs. 1 and 2. Devices 10 and 12 may be mounted on a common structure 18 in any convenient fashion. Digital controller 20 responds to an analog signal on line 22 coming from device 10 and generates a drive current in line 24 for device 12. Digital controller 20 generally comprises an analog to digital converter 26, control logic 28, and a digital to analog converter 30. Controller 20 is generally adapted for digital intercommunication with another digital device represented in Fig. 1 by digital system 32. Digital system 32 communicates control information to controller 20 via digital control word line 34.

Controller 20 reports status information to digital system 32 via digital status report word line 36. In most applications, light emitting device 12 is modulated in some fashion. The modulation information is generally communicated to controller 20 from digital system 32 via a code input line 38. As will become apparent, the modulation information can be communicated to controller 20 as well from some device other than system 32; it may be summed with the controlled output 24 rather than used to control the output; and it may be analog in nature rather than digital.

Although device 12 can be virtually any light emitting semiconductor device, such as an injection laser or light emitting diode (LED), the digital controller has particular features which are best used to advantage when the device is an injection laser. Accordingly, the controller implementation which will be described in detail will be a controller for an injection laser. It should be understood that with only minor changes which will be apparent to one of ordinary skill, the same controller could be used with other light emitting devices.

FIG. 2 illustrates my preferred embodiment for the controller, in which the analog to digital converter is implemented as a two threshold comparator 40, the control logic is implemented as an up/down counter 42, and the digital to analog converter is implemented as a digitally programmable current source 44. As will become more apparent, this controller has several different modes of operation and many different applications in which it can be used. In the embodiment shown in Fig. 2, the light emitting device is an injection laser 46 and the light sensitive device is a photodiode 48. In the application illustrated, the laser 46 is being used to transmit optical signals into an optical fiber 16. The input signal on line 50 may be either a two or more level digital signal or it may be analog. The optical signal generated by laser 46 will correspond in character with the input signal. For simplicity in description, the input signal is shown to be added to an output signal 52 from the digitally programmable current source 44. It should be understood that the two signals alternatively could be summed inside of current source 44. Also, the programmable current source instead could receive a coded input signal and decode and/or convert it into a component of the output signal 52.

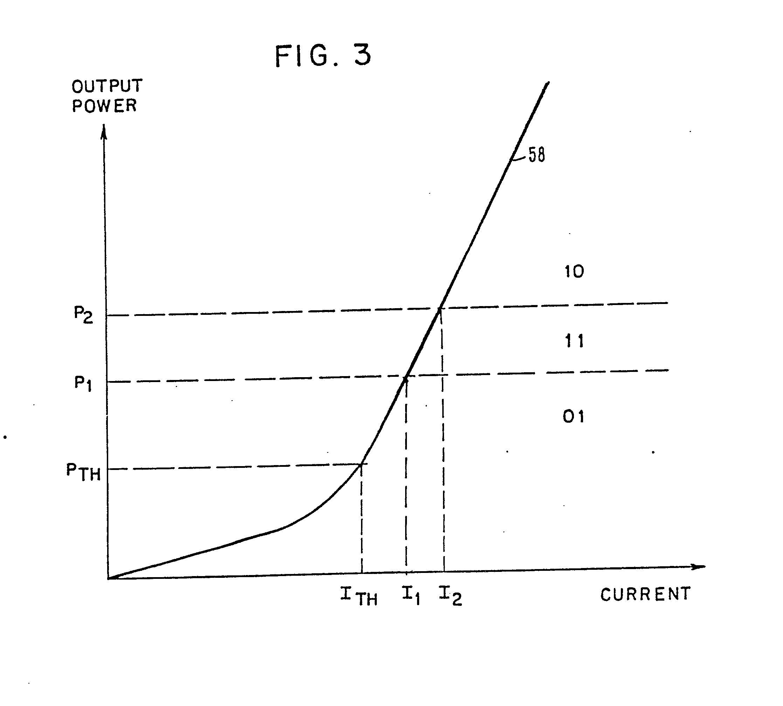

FIG. 3 is a graphical representation of the output power curve of a typical injection laser. When the drive current exceeds a threshold value $I_{TH}$, the device begins to lase. Following $I_{TH}$, there is an approximately linear region 58 where the device is fully lasing. The slope of region 58 is much steeper than that below $I_{TH}$. Superimposed on the optical power output curve is a definition of three regions. The laser will be controlled so that the average output power will stay within the region labeled with the binary code "11". Accordingly, region "11" is suitably spaced above $P_{TH}$ so that expected variations in the output power will not cross $P_{TH}$. On the other hand, the region "11" is not so far up the curve that the laser lifetime is unduly shortened thereby. Region "01" is defined as the power region below the "11" region, and region "10" is defined as the power region above the "11" region.

The two threshold comparator 40 determines whether the laser is operating in region "11" or in region "10" or in region "01". $P_1$ is the lower of the two thresholds and corresponds to a drive current of $I_1$. The other threshold is defined by $P_2$ and corresponding drive current $I_2$. Region "11" is defined as the power region between these two thresholds. Up/down counter 42 responds to the comparator 40 determination. When the laser is in region "11", the counter 42 holds the present count. When the laser is in region "01", counter 42 changes the count gradually in a direction such that laser power will tend to be increased thereby. When the laser is in region "10", counter 42 changes the count gradually in the opposite direction such that laser power will tend to be decreased thereby. The count of counter 42 is converted to a corresponding bias current for the laser by the digitally programmable current source 44.

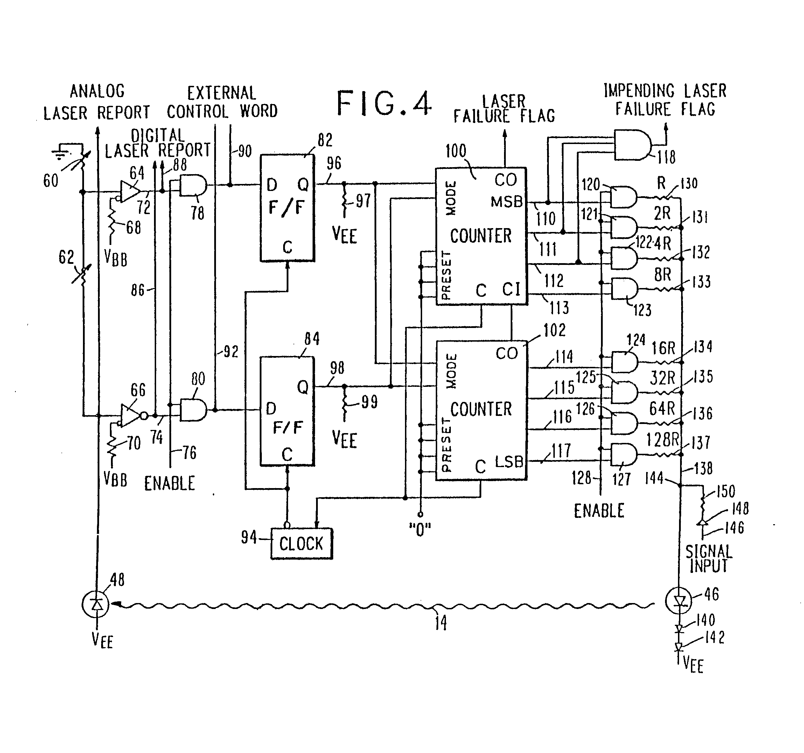

Fig. 4 is a more detailed schematical representation of the embodiment generally shown in Fig. 2. The logic topology illustrated in Fig. 4 has been designed to generate the codes illustrated in Fig. 3. Other topologies can be used to generate the same codes. The codes in Fig. 3 are those used in a commercially available logic chip used to implement part of this circuit. Other chips requiring other codes may be used in which case the topology of the logic must be modified accordingly. Fig. 4 also assumes an Emitter Coupled Logic implementation. Other logic technologies can be used and would result in obvious modifications. Photodiode 48 is positioned with respect to laser 46 such that it is illuminated by some of the light 14 emitted by laser 46. This light causes a photocurrent proportional to the light intensity to flow in the photodiode load circuit, which comprises a series connection of resistors 60, 62. The magnitude of this current is digitally encoded by resistors 60, 62 acting together with a first comparator 64 and a second comparator 66.

By proper selection of inverted and not-inverted inputs and outputs for comparators 64, 66 as well as by proper selection of the values for resistors 60, 62, 68 and 70, the logic code at the outputs 72, 74 of comparators 64, 66 is made to correspond with the code selections illustrated in Fig. 3. Thus, when the laser output power is less than $P_1$, the photocurrent flowing in the load circuit of photodiode 48 is such that the logic value at points 72, 74 is "01". When the laser output power is between $P_1$ and $P_2$, the logic value at points 72, 74 is "11". When the laser output power is above $P_2$, the logic value at points 72, 74 is "10".

A logic value of "0" on enable line 76 forces the output of the AND gates 78, 80 to "0" thus opening the feedback loop by preventing the logic value at points 72, 74 from being applied to the inputs of flip-flops 82, 84. The logic value at points 72, 74 is still available to an external system (such as digital system 32 or a microprocessor) via lines 86, 88. An externally generated logic value can be applied to the flip-flops in place of the logic value at points 72, 74 by applying such logic value to the inputs of flip-flops 82, 84 via lines 90, 92. When the logic value of enable line 76 is "1", AND gates 78, 80 apply the logic value at points 72, 74 to the inputs of flip-flops 82, 84. This is a conventional method for "ORing" logic signals in ECL systems. It may require OR gates in other logic families.

Assuming that enable line 76 is "1", the next not-clock pulse from clock 94 to the clock inputs of flip-flops 82, 84 causes the logic value at points 72, 74 to be loaded into flip-flops 82, 84. This causes the outputs 96, 98 of flip-flops 82, 84 to have the same logic value as points 72, 74.

Up/down counter 42 (Fig. 2) is implemented by connecting two hexadecimal counters 100, 102 in cascade. Counters 100, 102 each provide a 4 bit parallel output. The overflow "Carry Out" terminal (CO) of counter 102 is connected to the "Carry In" terminal (CI) of counter 100. The two counters 100, 102 thus function as a single counter which has an 8 binary bit counting range and an 8 bit parallel output.

Counters 100, 102 each have the following logic code governing operation. When the mode input is "11", the counters hold the count without change. When the mode input is "01", the counters increment by one count when a clock pulse from Clock 94 is received at the clock input (C). When the mode input is "10", the counters decrement by one count when a clock pulse is received at the clock input (C). When the mode input is "00", the counter loads the count represented on the preset terminals (PRESET). All of the preset terminals are connected to a logic level "0" potential as shown. A code of "00" occurs at points 96, 98 automatically upon initial turn on due to the presence of pull-up resistors 97, 99. Therefore, counters 100, 102 always start at a "00000000" count upon turn on. This protects the laser 46 from a possibly damaging transient at turn on.

Overflow of counter 100, indicated by its presence of a "1" at the carry out (CO) terminal, indicates that a light output within the "11" power range cannot be achieved by the feedback controller. This generally means that the laser 46 has failed. Therefore, an overflow count from counter 100 on its (CO) line is interpreted as a "Laser Failure Flag". A logic value of "1" simultaneously on all three of the most significant output bit lines 110, 111, 112 is interpreted as an impending failure of the laser as this indicates that 7/8 of the controller range has been utilized. This condition is detected by AND gate 118, a "1" output on which is interpreted as an "Impending Laser Failure Flag".

The output bit lines 110—117 of counters 100, 102 are each connected to an AND gate 120—127. The other input of each of these AND gates is connected to an Enable line 128. When AND gates 120—127 are enabled by a "1" on Enable line 128, the count on counters 100, 102 is transferred through the AND gates and is applied to a binary resistor ladder comprising resistors 130—137. The values of the resistors increase in value in binary fashion as indicated so that the sum of all the currents going through the resistors in the binary ladder is a discrete analog value corresponding to the count.

The binary ladder acts as a digital to analog converter or a digitally programmable current source. The sum of all the currents going through the binary ladder resistors is applied as a drive current to laser 46 via line 138. Other D/A resistor networks such as an R2R network may be used.

As is well known to those of ordinary skill in this art, pull up resistors must be used with ECL technology. Most of the pull up resistors have not been shown in order to simplify the schematic representation. One result of using ECL technology is that currents never go all the way to a zero value. Accordingly, some current flow in line 138 even when the count is "00000000". The D/A resistor network should be designed so that this current is not sufficient for laser 46 to reach threshold.

Diodes 140, 142 are provided to offset the logic supply voltage ($V_{EE}$ = 5.2 volts) so that the additional voltage drop across the laser diode 46 will provide the correct terminating voltage ($V_{TT}$ = 2 volts) to the resistors in the D/A network.

When the digital controller is used in an optical communications application, the sequence of internal operations of the controller is as follows: When power is turned on, the counter loads the preset zeros. Immediately thereafter the A/D converter encodes the laser output power as insufficient ("01"). This causes the counter to count up, thereby increasing at each count the bias current supplied to the laser by the D/A converter via line 38. This continues until the laser output power falls within the acceptable power range ("11") and is so encoded. A modulation signal may now be added to the bias current at node 144. A signal input on line 146 applies modulation current to this node via gate 148 and resistor 150. The modulation current will change the average power produced by the laser. If the excursion in the average power is sufficient to force it outside of the acceptable power range ("11"), then this will be encoded by the A/D converter and the counter will increment or decrement to compensate. In practice, the acceptable power range ("11") is selected so that its width is slightly greater than the average power variation which the input modulation signal will produce. The resolution of the programmable current source (D/A converter) is sufficiently great that at least one counter state exists such that the average power variations introduced by the modulating current will not cause changes in the counter state. After a brief period of operation, the counter is forced to this state (or one of these states). Once this status is achieved, the only phenomena which will cause the counter to change state are changes in the laser's average power caused by age or temperature.

When the controller is used instead in a peak power control modulation mode as may be needed in printing, recording or display applications, the sequence of internal operations of the controller is as follows: Logic level zero signals are supplied to the enable line 76 and the external control word lines 90, 92. Power is then applied to the controller and the counter loads the preset zeros. The sequence of digital signals which are to be represented as peak power controlled optical pulses is now applied to the enable line 76. As soon as the first logic level one is applied to this line, the control loop will be closed, the state of the laser will be encoded, and the counter will increment until the acceptable power range ("11") has been reached by the laser output. The acceptable power range will have been set to that required by the application by appropriately setting resistors 60, 62. The controller maintains the laser output power in the acceptable power range by the mechanism described earlier as long as the external control word enable 76 is kept at logic level one. When enable 76 is returned to logic level zero, the zero preset is again loaded into the counter causing the laser output to fall to zero. This cycle is repeated every time a pulse is applied to enable line 76. Enable 128 may also be used to achieve similar modulation of the laser drive current by setting the External Control word lines to "11" and the enable line 76 to zero after the laser is in the acceptable range. It will be necessary in this mode of operation to periodically re-enable the feedback loop in order to update the counter.

Enable line 76 and the external control word lines 90, 92 may be forced to logic level zero in order to turn the laser off. This signal may be supplied by an interlock switch on the cabinet in which the laser is mounted or by a signal from the system in which the laser is used. This feature provides means by which personnel may be protected from inadvertent exposure to the laser radiation. Enable line 128 may be used instead to accomplish the same function.

The controller can test the condition of the laser diode to which it is connected by supplying a logic level zero to enable line 76 and external control word line 92 and a logic level one to external control word line 90. This will cause the counter to count up continuously. The D/A converter will thus be ramped repetitively through its dynamic range. The current through the laser diode will thus range from some value below threshold to the peak current that the D/A converter can supply. The response of the laser diode to all currents in this range may then be examined either at the Analog Laser Report line or at a laser optical output port.

**Claims**

1. Feedback control circuit for a light emitting semiconductor device (46), comprising a sensor (48) for sensing the light output of the semiconductor device, a first comparator (66) responsive to said sensor for providing a first binary data signal according to whether the sensed light output is below or above a first predetermined level, a digital counter (100, 102) which counts up when the binary data signal indicates that the sensed light output is below said predetermined level, and a digital to analog converter (130—137) which generates drive current for the semiconductor device according to the count from the digital counter, characterised by a second comparator (64) responsive to said sensor for providing a second binary data signal according to whether the sensed light output is below or above a second predetermined level, and control logic (82, 84) responsive to said first and second binary data signals for controlling said digital counter, whereby when the light output from the semiconductor device is within an acceptable intermediate range, the digital counter remains static, and when the light output is below or above said intermediate range, the digital counter counts respectively up or down to increase or reduce the light output so that it is modified towards said intermediate range.

2. Feedback control circuit as claimed in claim 1 including a modulating signal input connection (144, 146) for modulating the generated drive current for the semiconductor device.

3. Feedback control circuit as claimed in claim 2 in which the power range of the generated drive current when the light output is within the acceptable intermediate range is selected so that it is slightly greater than the average power variation which said modulating signal will produce.

4. Feedback control circuit as claimed in any preceding claim in which the control logic comprises two clocked flip-flop circuits (82, 84) responsive respectively to the first and second binary data signals.

5. Feedback control circuit as claimed in any preceding claim in which said digital counter includes a failure flag circuit (CO of counter 100 or AND circuit 118) for the semiconductor device.

**Patentansprüche**

1. Rückkopplungsteuerschaltung für eine Licht emittierende Halbeitervorrichtung (46), welche einen Sensor (48) zum Abfühlen des Lichtausgangssignals der Halbleitervorrichtung, einen auf den Sensor ansprechenden ersten Komparator (66) zur Lieferung eines ersten Binärdatensignals in Entsprechung dazu, ob das abgefühlte Lichtausgangssignal unterhalb oder oberhalb eines ersten bestimmten Wertes liegt, einen Digitalzählers (100, 102), welcher hochzählt, wenn das Binärdatensignal angibt, daß das abgefühlte Lichtausgangssignal unterhalb des bestimmten Werts liegt, und einen Digital-Analogwandler (130 bis 137), welcher Treiberstrom für die Halbleitervorrichtung entsprechend der Zählung des Digitalzählers erzeugt, umfaßt, gekennzeichnet durch einen auf den Sensor ansprechenden zweiten Komparator (64) zur Lieferung eines zweiten Binärdatensignals in Entsprechung dazu, ob das abgefühlte Lichtausgangssignal unterhalb oder oberhalb eines zweiten bestimmten Wertes liegt, und eine auf das erste und das zweite Binärdatensignal ansprechende Steuerlogik (82, 84) zur Steuerung des Digitalzählers, wodurch, wenn das Lichtausgangssignal der Halbleitervorrichtung innerhalb eines annehmbaren Zwischenbereiches liegt, der Digitalzähler statisch bleibt, und wenn das Lichtausgangssignal unterhalb oder oberhalb des Zwischenbereiches liegt, der Digitalzähler hoch- bzw. abwärts zählt, um das Lichtausgangssignal zu erhöhen oder zu vermindern, so daß es auf den Zwischenbereich hin abgeändert wird.

2. Rückkopplungssteuerschaltung nach Anspruch 1, welche einen Modulationssignaleingangsanschluß (144, 146) zur Modulation des erzeugten Treiberstroms für die Halbleitervorrichtung enthält.

3. Rückkopplungssteuerschaltung nach Anspruch 2, bei welcher, wenn das Lichtausgangssignal innerhalb des annehmbaren Zwischenbereichs liegt, der Leistungsbereich des erzeugten Treiberstroms so gewählt ist, daß er geringfügig größer als die mittlere Leistungsschwankung ist, welche das Modulationssignal erzeugt.

4. Rückkopplungssteuerschaltung nach irgendeinem vorstehenden Anspruch, bei welcher die Steuerlogik zwei getaktete Flip-Flop-Schaltungen (82, 84) umfaßt, welche auf das erste bzw. das zweite Binärdatensignal ansprechen.

5. Rückkopplungssteuerschaltung nach irgendeinem vorstehenden Anspruch, bei welcher der Digitalzähler eine Fehlerkennzeichenschaltung (CO des Zählers 100 oder UND-Schaltung 118) für die Halbleitervorrichtung enthält.

**Revendications**

1. Circuit de commande de rétroaction pour un dispositif semi-conducteur émetteur de lumière (46), comprenant un détecteur (48) pour détecter la lumière sortant du dispositif semi-conducteur, un premier comparateur (66) réagissant audit détecteur pour produire un premier signal de donnée binaire suivant que la lumière détectée à la sortie est inférieure ou supérieure à un premier niveau prédéterminé, un compteur numérique (100, 102) qui effectue un comptage croissant lorsque le signal de donnée binaire indique que la lumière détectée à la sortie est inférieure audit niveau prédéterminé, et un convertisseur numérique-analogique (130—137) qui produit un courant d'excitation du dispositif semi-conducteur en fonction du compte fourni par le compteur numérique, caractérisé par un second comparateur (64) réagissant audit détecteur pour produire un second signal de donnée binaire suivant que la lumière détectée à la sortie est inférieure ou supérieure à un second niveau prédéterminé, et une logique de commande (82, 84) réagissant auxdits premier et second signaux de donnée binaire pour commander ledit compteur numérique, de telle sorte que, lorsque la lumière sortant du dispositif semiconducteur rentre dans une gamme intermédiaire acceptable, le compteur numérique reste statique et que, lorsque la lumière sortante est au-dessus ou en dessous de ladite gamme intermédiaire, le compteur numérique effectue respectivement un comptage croissant ou décroissant afin d'uagmenter ou de réduire la lumière sortante pour la faire rentrer dans ladite gamme intermédiaire.

2. Circuit de commande de rétroaction comme revendiqué dans la revendication 1, comprenant une connexion d'entrée de signal de modulation (144, 146) pour moduler le courant d'excitation engendré pour le dispositif semi-conducteur.

3. Circuit de commande de rétroaction comme revendiqué dans la revendication 2, dans lequel la gamme de puissance du courant d'excitation engendré quand la lumière sortante rentre dans ladite gamme intermédiaire acceptable est sélectionnée de façon à êtrelégérement supérieure à la variation moyenne de puissance que ledit signal de modulation produit.

4. Circuit de commande de rétroaction comme revendiqué dans l'une quelconque des revendications précédentes, dans lequel la logique de commande comprend deux circuits bistables synchronisés (82 et 84) répondant respectivement au premier et au second signal de données binaires.

5. Circuit de commande de rétroaction comme revendiqué dans l'une quelconque des revendication précédentes, dans lequel ledit compteur numérique comprend un circuit (CO du compteur 100 ou circuit ET 118) d'indication de panne du dispositif semi-conducteur.

FIG.1

DIGITAL SYSTEM — 32

DIGITAL CONTROL WORD

36 — DIGITAL STATUS REPORT WORD

CODE INPUT 38

34

26

A/D

CONTROL LOGIC

D/A — 20

22

28

30

24

18

16

10

14

14

12

FIG.2

40

42

44

TWO THRESHOLD COMPARATOR

UP/DOWN COUNTER

DIGITALLY PROGRAMMABLE CURRENT SOURCE

52

50 — INPUT SIGNAL

16

48

46

14

14

# FIG. 3

FIG.4